# EUROPÄISCHE PATENTSCHRIFT

(11) **EP 1 518 885 B1**
(45) Veröffentlichungstag und Bekanntmachung des Hinweises auf die Patenterteilung: **02.08.2006**
(21) Anmeldenummer: 04022018.8
(22) Anmeldetag: 16.09.2004
(51) Int. Cl.: C08J 5/18, C08J 7/04, C08K 3/22, C08L 67/02, C23C 18/16, H05K 3/18

(54) **Orientierte, mittels elektromagnetischer Strahlung strukturierbare und mit Aminosilan beschichtete Folie aus thermoplastischem Polyester zur Herstellung selektiv metallisierter Folien**
Oriented, with electromagnetic radiation patternable and aminosilane coated foil made of thermoplastic polyester for the production of selectively metallized foils
Feuille orientée, structurable par rayonnement électromagnétique et enduite avec d'aminosilane, à base de polyester thermoplastique, pour la préparation de feuilles métallisées sélectivement

(30) Priorität: 24.09.2003 DE 10344511
(43) Veröffentlichungstag der Anmeldung: 30.03.2005
(73) Patentinhaber: Mitsubishi Polyester Film GmbH, 65203 Wiesbaden (DE)
(72) Erfinder: Kliesch, Holger, Dr., 55252 Mainz (DE); Kiehne, Thorsten, Dr., 65185 Wiesbaden (DE); Hilkert, Gottfried, Dr., 55291 Saulheim (DE); Fischer, Ingo, 65558 Heistenbach (DE)
(74) Vertreter: Schweitzer, Klaus

(56) Entgegenhaltungen:
- EP-A- 1 274 288
- EP-B- 0 359 017
- US-A- 5 470 637
- PATENT ABSTRACTS OF JAPAN Bd. 1995, Nr. 09, 31. Oktober 1995 (1995-10-31) & JP 7 166034 A (TEIJIN LTD), 27. Juni 1995 (1995-06-27)

## Beschreibung

Die Erfindung betrifft eine ein- oder mehrschichtige, orientierte, mit einer Aminosilanverbindung beschichtete Folie aus Polyester, der ein Additiv enthält, welches unter Bestrahlung mit elektromagnetischer Strahlung Metallkeime bildet, an denen sich in weiteren Prozessschritten weiteres Metall anlagern lässt. Die Erfindung betrifft ferner ein Verfahren zur Herstellung dieser Folie und ihre Verwendung in Leiterplatten, Flachbandkabeln, Smartcards, RFID-Labels, Folientastaturen und folienbasierten Schaltungen aller Art.

Die Verwendung von Polyesterfolien für Elektroisolieranwendungen ist Stand der Technik. Die immer höheren Anforderungen hinsichtlich Komplexität der Schaltungen auf kleinem Raum sowie die Notwendigkeit solche Schaltungen schnell, flexibel und kostengünstig produzieren zu können, stellt hohe technologische Anforderungen an die Folie und die Weiterverarbeitungsschritte.

Konventionelle Verfahren zur Herstellung flexibler Schaltungen betreffen meist die vollflächige Metallisierung der Folienbahn oder Kaschierung der Folienbahn mit Metallfolie und anschließendes Strukturieren der so entstandenen leitfähigen Flächen mit verschiedenen Verfahren, z.B. Ätzen oder mechanisches Entfernen der unerwünschten Metallmengen. Oder aber Verfahren, bei denen das Metall aufgeprägt/aufgedruckt wird, oder eine Leitpaste aus Kohle/Silber aufgetragen wird. Nachteile dieser Verfahren liegen in der geringen Flexibilität und Präzision solcher Verfahren, welche einen größeren Abstand der Leiterbahnen untereinander bedingt und/oder der hohen mit diesen Verfahren verbundenen Kosten und/oder der niedrigen Produktionsgeschwindigkeiten.

In EP-A-1 274 288 wird ein Verfahren beschrieben, bei dem aus kupferhaltigen Metalloxiden durch Laserbestrahlung Kupferkeime gebildet werden, an denen in einem anschließenden Galvanisierungsschritt weiteres Kupfer abgeschieden wird. In dieser Druckschrift werden ausschließlich Spritzgussteile beschrieben und es fehlen Hinweise wie und ob das Verfahren für Polyesterfolien und Folien im Allgemeinen angewendet werden kann. Insbesondere fehlen Hinweise, wie die Rohstoffe und Additive beschaffen sein müssen, um daraus orientierte Folien herstellen zu können. Das in der EP-A-1 274 288 beschriebene PBT / SiO₂ / Spinell Compound ist zur Herstellung orientierter Folien ungeeignet, da das verwendetete Polybutylenterephthalat aufgrund seiner hohen Kristallisationsgeschwindigkeit und des hohen Füllgrads mit pyrogener Kieselsäure nicht verfahrenssicher verarbeitbar ist.

Insbesondere fehlen Hinweise wie eine Folie mit hinreichender Dimensionsstabilität bei lokaler Erwärmung nach Bestrahlung mit elektromagnetischer Strahlung und Weiterverarbeitung hergestellt werden kann.

Aufgabe der vorliegenden Erfindung war es, eine Folie bereitzustellen, welche die genannten Nachteile nicht aufweist und die eine strahlungsaktivierbare Verbindung enthält, die Metallkeime bildet, an denen sich in weiteren Verfahrensschritten zusätzliches Metall in der Weise anlagern lässt, dass eine gute Haftung zwischen Folie und Metall erzielt wird. Weiterhin sollte eine solche Folie neben einer wirtschaftlichen Herstellung und einer guten Verstreckbarkeit, gute mechanische Eigenschaften, das bedeutet eine hohe Reißfestigkeit in Längs- und Querrichtung, einen hohen E-Modul in Längs- und Querrichtung, eine hohe Reißdehnung in Längs- und Querrichtung und eine hohe Zugspannung zur Erzeugung einer Dehnung von 5 % (F5-Wert) in Längs-und Querrichtung aufweisen sowie einen definierten Schrumpf aufweisen.

Gelöst wird diese Aufgabe durch eine ein- oder mehrschichtige, mindestens uniaxial gestreckte Polyesterfolie mit einer Gesamtdicke von 5 - 500 µm (bevorzugt 12 - 200 µm und besonders bevorzugt 30 -150 µm), die in mindestens einer Schicht eine durch elektromagnetische Strahlung aktivierbare Metallverbindung enthält, bevorzugt in einer Menge von 0,1 - 15 Gew.-% (besonders bevorzugt 1,0 - 10 Gew.-% und ganz besonders bevorzugt 2,0 - 8,0 Gew.-%), bezogen auf das Gesamtgewicht der ausgerüsteten Schicht, und die mindestens einseitig mit einer Aminosilanbeschichtung versehen ist.

Unter einer strahlungsaktivierbaren Metallverbindung ist eine metailhaitige (anorganische oder organische) Verbindung zu verstehen, die infolge einer Absorption von elektromagnetischer Strahlung in einer chemischen Reaktion Metall in elementarer Form freisetzt. Diese chemische Reaktion kann auch unter Beteiligung weiterer Reaktionspartner erfolgen. Weiterhin ist es möglich, dass die elektromagnetische Strahlung nicht direkt von der metallhaltigen Verbindung absorbiert wird, sondern durch andere Substanzen, die anschließend die absorbierte Energie auf die metallhaltige Verbindung übertragen und so die Freisetzung von elementarem Metall bewirken. Bei der elektromagnetischen Strahlung kann es sich um UV-Licht (Wellenlänge 100 - 400 nm), sichtbares Licht (Wellenlänge 400 - 800 nm) oder Infrarotlicht (Wellenlänge 800 - 25000 nm) handeln, wobei die Verwendung von Infrarotlicht bevorzugt ist. Weitere geeignete Strahlungsformen sind Röntgen-, Gamma- und Partikelstrahlung (Elektronen-, α- und β-Strahlung).

Die Anlagerung von zusätzlichem Metall an die durch elektromagnetische Strahlung erzeugten Metallkeime erfolgt bevorzugt durch galvanische (nasschemische) Verfahren.

Eine gute Haftung zwischen dem abgeschiedenen Metall und der Folie bedeutet, dass das Metall nicht, z.B. nach Aufkleben und nachfolgendem Abziehen eines Klebestreifens, von der Folie entfernt werden kann.

Zu einer guten Verstreckbarkeit zählt, dass sich die Folie bei ihrer Herstellung hervorragend uniaxial oder biaxial ohne Abrisse orientieren lässt.

Zu den guten mechanischen Eigenschaften zählen unter anderem ein hoher E-Modul in mindestens einer Folienrichtung (Längsrichtung (MD) und/oder Querrichtung (TD)) von größer als 500 N/mm², bevorzugt größer als 2000 N/mm² und besonders bevorzugt von größer als 4000 N/mm², sowie hohe Reißfestigkeitswerte in mindestens einer Folienrichtung (Längsrichtung (MD) und/oder Querrichtung (TD)) von größer als 50 N/mm², bevorzugt größer als 100 N/mm² und besonders bevorzugt von größer als 150 N/mm², hohe Reißdehnungswerte in mindestens einer Folienrichtung (Längsrichtung (MD) und/oder Querrichtung (TD)) von größer als 10 % bevorzugt größer als 40 % und besonders bevorzugt von größer als 80 %.

Die erfindungsgemäße Folie weist in einer bevorzugten Ausführungsform in keiner Folienrichtung (weder in MD noch in TD) einen Schrumpf bei 200 °C von größer 25 % auf. Der Schrumpf bei 200 °C ist bevorzugt kleiner als 15 % und besonders bevorzugt kleiner als 5 %.

Die erfindungsgemäße Folie basiert auf Polyestern. Insbesondere im Falle von mehrschichtigen Folien enthalten die Basisschicht, aber auch die Deck- und oder Zwischenschichten als Hauptpolymerbestandteil (d.h. zu 55 - 100 Gew.-%, bevorzugt 70 - 100 Gew.-% und besonders bevorzugt 90 - 100 Gew.-%, bezogen auf die Masse der jeweiligen Schicht) einen Polyester.

Erfindungsgemäß versteht man unter einem Polyester
- Homopolyester,
- Copolyester,
- Blends verschiedener Polyester,
wobei diese sowohl als reine Rohstoffe, als auch als Rezyklat enthaltende Polyester-Rohstoffe eingesetzt werden können.

Polyester enthalten Wiederholungseinheiten, die sich von Dicarbonsäuren (100 Mol-%) und Diolen (ebenfalls 100 Mol-%) ableiten. Die erfindungsgemäßen Polyester basieren bevorzugt auf Terephthalsäure oder 2,6-Naphthalindicarbonsäure als Dicarbonsäure und auf Ethylenglykol als Diol.

Insbesondere enthalten die erfindungsgemäßen Polyester 10 - 100 Mol-% Terephthalat oder 10 - 100 Mol-% 2,6-Naphthalat als Dicarbonsäurekomponeneten (wobei die Gesamtmenge an Dicarbonsäurekomponeten 100 Mol-% ausmachen). Als weitere Dicarbonsäurekomponeneten kann der erfindungsgemäße Polyester 0 - 50 Mol-% 2,6-Naphthalat (wenn als Hauptkomponente Terephthalat eingesetzt wurde), 0 - 50 Mol-% Terephthalat (wenn als Hauptkomponente Naphthalat verwendet wurde), 0 - 20 Mol-% Isophthalat (bevorzugt 0,5 - 4 Mol-%) sowie 10 - 60 Mol-% 4,4'-Diphenyldicarboxylat enthalten. Andere Dicarbonsäurekomponeneten wie 1,5-Naphthalindicarboxylat sollten einen Anteil von 30 Mol-%, bevorzugt 10 Mol-%, insbesondere 2 Mol-%, nicht überschreiten.

Als Diolkomponente enthält der erfindungsgemäße Polyester 10-100 Mol-% Ethylenglykol (EG) (wobei die Gesamtmenge an Diolkomponenten 100 Mol-% ausmachen). Der Anteil an Diethylenglykol sollte 10 Mol-% nicht überschreiten und liegt idealerweise zwischen 0,5 und 5 Mol-%. Andere Diolkomponenten wie Cyclohexandimethanol, 1,3-Propandiol, 1,4-Butandiol sollten einen Anteil von 50 Mol-% nicht überschreiten und liegen bevorzugt bei einem Anteil von weniger als 30 Mol-%, besonders bevorzugt bei weniger als 10 Mol-%.

Die Polyesterzusammensetzung funktioneller Deckschichten kann von dem oben beschriebenen abweichen und ist z.B. im Absatz über siegelfähige Deckschichten weiter unten beschrieben.

Neben den genannten Hauptpolymerbestandteilen können die Schichten der Folie in weiteren Ausführungsformen bis zu 45 Gew.-% (bevorzugt bis zu 30 Gew.-%, besonders bevorzugt bis zu 20 Gew.-%, bezogen auf die Masse der jeweiligen Folienschicht) andere Polymere wie Polyetherimide (z.B. ® Ultem 1000 von GE Plastics Europe, NL), Polycarbonat (z.B. ® Makrolon von Bayer, DE), Polyolefine wie COCs (z.B. ® Topas von Ticona, DE), Polyamide (® Ultramid von BASF, DE) u.a. enthalten.

Allgemein werden die Polyester nach literaturbekannten Verfahren aus den genannten Diolen und Dicarbonsäure oder Dicarbonsäureester hergestellt. Die Herstellung der Polyester kann sowohl nach dem Umesterungsverfahren mit den üblichen Katalysatoren wie z.B. Zn-, Ca-, Li- und Mn-Salzen oder nach dem Direktveresterungsverfahren erfolgen.

Die erfindungsgemäße Folie kann ein oder mehrschichtig sein. Mehrschichtige Folien bestehen aus einer Basisschicht B, mindestens einer Deckschicht A oder C und gegebenenfalls weiteren Zwischenschichten, wobei insbesondere ein dreischichtiger A-B-A- oder A-B-C-Aufbau bevorzugt ist. Für diese Ausführungsform ist es vorteilhaft, wenn das Polymer der Basisschicht B eine ähnliche Schmelzeviskosität besitzt wie jene(s) der Deckschicht(en), die an die Basisschicht angrenzt (angrenzen).

In einer möglichen Ausführungsform ist die funktionelle Schicht C siegelfähig. Diese durch Koextrusion auf die Basisschicht B aufgebrachte siegelfähige Deckschicht ist zweckmäßigerweise auf Basis von Polyestercopolymeren aufgebaut. Bevorzugt im Sinne der Erfindung sind dabei zwei Varianten: entweder Copolyester aus Terephthalsäure und Isophthalsäure oder Copolyester aus Terephthalsäure und Naphthalindicarbonsäure.

Das Polymer der siegelfähige Deckschicht besteht dann aus Copolyestern, die überwiegend, das heißt zu mindestens 70-95 Mol-% aus entweder Isophthalsäure- oder Naphthalindicarbonsäure- und Terephthalsäure-Komponenten auf der Dicarbonsäure-Seite und 70-95 Mol-% aus Ethylenglykol-Komponenten auf der Diol-Seite zusammengesetzt sind. Die restlichen Monomereinheiten stammen aus anderen aliphatischen, cycloaliphatischen oder aromatischen Diolen bzw. Dicarbonsäuren, wie sie auch in der Basisschicht vorkommen können.

Die Dicke der Deckschicht/en wird unabhängig von den anderen Schichten gewählt und liegt bevorzugt im Bereich von 0,1 bis 10 µm, insbesondere 0,2 bis 5 µm, vorzugsweise 1 bis 3 µm, wobei beidseitig aufgebrachte Deckschichten bezüglich Dicke und Zusammensetzung gleich oder verschieden sein können. Die Dicke der Basisschicht ergibt sich entsprechend aus der Differenz von Gesamtdicke der Folie und der Dicke der aufgebrachten Deck- und Zwischenschicht/en und kann daher analog der Gesamtdicke innerhalb weiter Grenzen variieren.

Die strahlungsaktivierbare Verbindung besteht aus elektrisch nichtleitenden thermisch hochstabilen organischen oder anorganischen Metallverbindungen, die bevorzugt in wässrigen sauren oder alkalischen Metallisierungsbädern beständig und nicht löslich sind. Besonders geeignet sind solche Verbindungen, die Licht, insbesondere im IR-Bereich möglichst vollständig absorbieren. Solche Verbindungen sind in EP-A-1 274 288 beschrieben. Bevorzugt sind hierbei Verbindungen von Metallen der d- und f-Gruppe des Periodischen Systems mit Nichtmetallen. Besonders bevorzugt handelt es sich bei den metallhaltigen Verbindungen um Metalloxide, insbesondere um Monoxide der d-Metalle des Periodischen Systems. Besonders geeignet sind höhere Metalloxide. Gemäß einer besonders bevorzugten Ausführungsform der Erfindung sind die höheren Oxide Spinelle, insbesondere kupferhaltige Spinelle wie CuCr₂O₄. Geeignete kupferhaltige Spinelle sind kommerziell erhältlich, so z.B. der Typ PK 3095 der Fa. Ferro (DE) oder die Typen 34E23 oder 34E30 der Firma Johnson Matthey (DE).

Die erfindungsgemäße Folie enthält diese Verbindungen in einer Konzentration von 0,1 - 15 Gew.-%, bevorzugt 1,0 - 10 Gew.-% und besonders bevorzugt 2,0 - 8,0 Gew.-%. Diese Gesamtkonzentration kann sich hierbei auf zwei oder mehrere Schichten der Folie verteilen, bevorzugt wird die Gesamtmenge jedoch den Deckschichten, bevorzugt einer der Deckschichten zugegeben.

Sofern die metallhaltige Verbindung in dem zur Folienherstellung verwendeten Polyester nicht löslich ist, handelt es sich um Partikel mit einer mittleren Größe (d₅₀-Wert) von 0,01 - 20 µm, bevorzugt 0,05 - 10 µm und besonders bevorzugt 0,1 - 5 µm.

Mehr als überraschend war hierbei, dass es völlig ausreicht ausschließlich die, im Verhältnis zur Gesamtdicke der Folie, dünne(n) Deckschicht(en) der Folie mit der beschriebenen strahlungsaktivierbaren Verbindung auszurüsten, um eine durch elektromagnetische Strahlung strukturierbare Folie zu erhalten, die für die genannten Anwendungen geeignet ist. Von besonderem wirtschaftlichen Vorteil ist in diesem Fall, dass insgesamt eine erheblich geringere Menge der strahlungsaktivierbaren Verbindung zur Herstellung der erfindungsgemäßen Folie notwendig ist, als bei zusätzlichen Ausrüstung der Basisschicht oder bei Ausrüstung der gesamten Folie.

Die erfindungsgemäße Folie kann in einer oder mehreren Schichten weitere partikuläre Additive wie Füllstoffe und Antiblockmittel enthalten. Typische Füllstoffe und Antiblockmittel sind anorganische und/oder organische Partikel, beispielsweise Siliciumdioxid (gefällt oder pyrogen), Calciumcarbonat, Magnesiumcarbonat, Bariumcarbonat, Calciumsulfat, Bariumsulfat, Lithiumphosphat, Calciumphosphat, Magnesiumphosphat, Titandioxid (Rutil oder Anatas), Kaolin (hydratisiert oder calciniert), Aluminiumoxid, Aluminiumsilikate, Lithiumfluorid, Calcium-, Barium-, Zink- oder Mangansalze der eingesetzten Dicarbonsäuren oder vernetzte Polymerpartikel, z.B. Polystyrol oder Polymethylmethacrylatpartikel.

Es können auch Mischungen von zwei oder mehreren der oben genannten Partikelsysteme oder Mischungen von Partikelsystemen mit gleicher chemischer Zusammensetzung, aber unterschiedlicher Partikelgröße gewählt werden. Die Partikel werden dem Polyester zweckmäßigerweise schon vor dem Aufschmelzen zugesetzt.

Sofern in einer Schicht der Folie weitere partikuläre Additive enthalten sind, beträgt die Gesamtkonzentration dieser Partikel weniger als 30 Gew.-% bezogen auf die Gesamtmasse der ausgerüsteten Schicht, bevorzugt weniger als 25 Gew.-% und besonders bevorzugt weniger als 20 Gew.-%. Die partikulären Additive haben eine mittlere Größe (d₅₀-Wert) von 0,01 - 15 µm, bevorzugt 0,03 - 10 µm und besonders bevorzugt 0,05 - 1 µm. In einer bevorzugten Ausführungsform liegt der Anteil von Partikeln mit einem d₅₀ > 3 µm bei kleiner 2000 ppm und besonders bevorzugt bei < 1000 ppm.

Es hat sich gezeigt, dass auch Folien ohne weitere Additive (außer der aktiven Metallkomponente) gemäß der Erfindung eingesetzt werden können. Die Bildung der Metallkeime wird jedoch verbessert, wenn mindestens eine Schicht der Folie als Füllstoff Siliciumdioxid in den oben genannten Mengen und Teilchengrößen enthält. Für die Bildung der Metallkeime hat es sich als besonders günstig erwiesen, wenn die Folie in der (den) mit der strahlungsaktivierbaren Komponente ausgerüsteten Schicht(en) zusätzlich 0,1 bis 30 Gew.-%, bevorzugt 0,5 bis 25 Gew.-% und besonders bevorzugt 1 bis 20 Gew.-% (bezogen auf die Gesamtmasse der ausgerüsteten Schicht), Siliciumdioxid-Partikel mit einem d₅₀ < 1 µm enthält (enthalten).

Die erfindungsgemäße Folie kann weitere Additive wie UV-Stabilisatoren, Flammschutzmittel, Hydrolysestabilisatoren und Antioxidantien enthalten.

In einer weiteren Ausführungsform ist die erfindungsgemäße Folie in mindestens einer ihrer Schichten flammhemmend ausgerüstet. Flammhemmend bedeutet, dass die Folie in einer so genannten Brandschutzprüfung gemäß UL94 VTM mindestens die Klasse VTM-2 erreichen. Die Folie enthält dann in einer oder mehreren Schichten ein Flammschutzmittel in einer Konzentration im Bereich von 0,2 bis 30 Gew.-%, bevorzugt 0,5 bis 25 Gew.-%, besonders bevorzugt von 1,0 bis 20 Gew.-%, bezogen auf die Masse der ausgerüsteten Schicht. Wesentlich ist, dass das Flammschutzmittel im Polyester löslich ist, da andernfalls die geforderten mechanischen Eigenschaften nicht erreicht werden. Geeignete Flammschutzmittel sind beispielsweise organische Brom-, Chlor- oder Stickstoffverbindungen oder Metallhydroxide oder -trihydrate. Die Halogenverbindungen haben allerdings den Nachteil, dass im Brandfall toxische und korrosiv wirkende Halogenwasserstoffe entstehen. Nachteilig ist auch die geringe Lichtbeständigkeit einer damit ausgerüsteten Folie. Weitere geeignete Flammschutzmittel sind beispielsweise organische Phosphorverbindungen wie Carboxyphosphinsäuren, deren Anhydride und Methanphosphonsäuredimethylester. Sehr geeignet sind hierbei Flammschutzmittel, bei denen die Phosphorverbindung chemisch an den Polyester gebunden ist. Ganz besonders bevorzugt ist [(6-oxido-6H-dibenz[c,e][1,2]oxaphos-phorin-6-yl)methyl]butandicarbonsäure-bis-(2-hydroxyethyl)ester mit der Formel

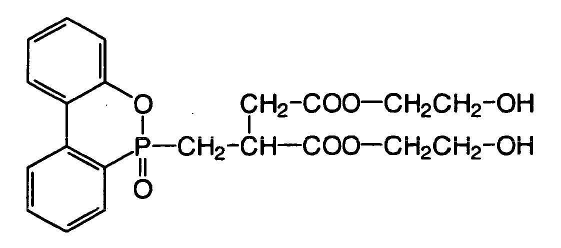

In dieser bevorzugten Ausführungsform enthält die erfindungsgemäße schwer entflammbare Folie neben dem Polyester, der strahlungsaktivierbaren Verbindung und gegebenenfalls partikulären Additiven, 1 bis 20 Gew.-% einer im Polyester löslichen organischen Phosphorverbindung als Flammschutzmittel.

Da die Flammschutzmittel im allgemeinen eine gewisse Hydrolyseempfindlichkeit aufweisen, kann der zusätzliche Einsatz eines Hydrolysestabilisators sinnvoll sein. Geeignete Hydrolysestabilisatoren sind beispielsweise polymere Carbodiimide wie z.B. ® Stabaxol P von Fa. Rheinchemie (DE). Diese werden bevorzugt in einer Menge von 0,1 bis 1,0 Gew.-% (bezogen auf die Masse der ausgerüsteten Schicht) eingesetzt.

Diese oben genannten Anteile an Flammschutzmittel und Hydrolysestabilisator haben sich auch dann als günstig erwiesen, wenn der Hauptbestandteil der Folie nicht Polyethylenterephthalat, sondern ein anderer Polyester ist.

Die strahlungsaktivierbare Verbindung und die ggf. verwendeten weiteren Additive wie Partikel, UV-Stabilisatoren, Flammschutzmittel, Hydrolysestabilisatoren und Antioxidantien können dem zur Herstellung der erfindungsgemäßen Folie verwendeten Polyester als glykolische Dispersion während der Polykondensation zugegeben werden. Bevorzugt ist jedoch die Zugabe der strahlungsaktivierbaren Komponente und/oder der ggf. verwendeten weiteren Additive über Masterbatche zum Polyesterrohstoff während der Folienextrusion.

Erfindungsgemäß wird mindestens eine Oberfläche der Folie mit einer wässrigen Lösung bzw. Dispersion einer hydrolysierten Aminosilanverbindung beschichtet. Die Beschichtung wird bevorzugt in-line aufgebracht, d.h. während des Folienherstellungsprozesses, zweckmäßigerweise vor der Querstreckung. Besonders bevorzugt ist die Aufbringung der Beschichtung mittels des "Reverse Gravure Roll Coating"-Verfahrens, bei dem sich die Beschichtung äußerst homogen auftragen lässt. Ebenfalls bevorzugt ist die Aufbringung der Beschichtung durch das "Meyer-Rod"-Verfahren, mit dem sich größere Beschichtungsstärken erzielen lassen. Die Beschichtung wird als verdünnte wässrige Lösung bzw. Dispersion auf die Folie gebracht und anschließend das Lösungsmittel bzw. Dispersionsmittel verflüchtigt. Wird die Beschichtung in-line vor der Querstreckung aufgebracht, reicht gewöhnlich die Temperaturbehandlung in der Querstreckung aus, um das Lösungsmittel bzw. Dispersionsmittel zu verflüchtigen und die Beschichtung zu trocknen.

Geeignete Aminosilanverbindungen haben im unhydrolysierten Zustand die allgemeine Formel

(R¹)ₐSi(R²)_{b}(R³)_{c},

wobei R¹ eine funktionelle Gruppe mit mindestens einer primären Aminogruppe ist, bevorzugt eine Gruppe mit der Formel -X-Y-Z-NH₂ mit X=C1-C4-Alkylen o. C6-C10-Arylen, Y= O, NH oder eine Bindung, Z=C1-C4-Alkylen o. C6-C10-Arylen, R² eine hydrolysierbare Gruppe, ausgewählt aus der Gruppe, bestehend aus einer Alkoxygruppe mit 1 - 8 Kohlenstoffatomen, einer Acetoxygruppe und einem Halogenid, und R³ eine unreaktive, nicht hydrolysierbare Gruppe, ausgewählt aus der Gruppe, bestehend aus einer Alkylgruppe mit 1 - 8 Kohlenstoffatomen und einer Phenylgruppe, bedeutet. Der Koeffizient a ist größer oder gleich 1, der Koeffizient b ist ebenfalls größer oder gleich 1, der Koeffizient c ist größer oder gleich 0 und a+b+c = 4.

Als Aminosilanverbindung ist N-(2-Aminoethyl)-3-aminopropyltrimethoxysilan der Formel 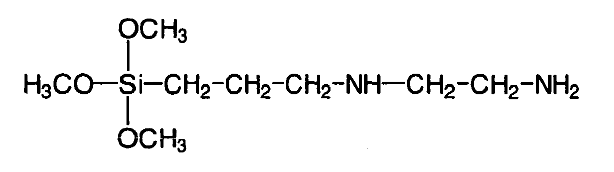 bevorzugt. Diese Verbindung wird unter der Bezeichnung Z-6020 kommerziell von der Fa. Dow Corning (DE) angeboten.

Die oben beschriebene erfindungsgemäße Beschichtung ist ausführlich in EP-B-359 017 beschrieben, auf die an dieser Stelle ausdrücklich Bezug genommen wird. Diese Druckschrift beschreibt auch weitere geeignete Aminosilanverbindungen, auf deren Wiedergabe hier verzichtet wird, die aber von der vorliegenden Erfindung ausdrücklich mit umfasst sind.

Völlig überraschend hat sich gezeigt, dass eine Folie, die mindestens eine strahlungsaktivierbare Verbindung enthält und die mit dem getrockneten Rückstand einer hydrolysierten Aminosilanverbindung in einer Menge von 0,5 bis 100 mg/m² (bevorzugt 2 bis 50 mg/m² und besonders bevorzugt 10 bis 25 mg/m²) beschichtet ist, nach Aktivierung und nachfolgender Abscheidung von Metall auf der beschichteten Seite eine deutlich verbesserte Haftung des Metalls auf der Folie zeigt.

Die Folie kann auch auf der nicht mit hydrolysierten Aminosilanverbindungen beschichteten Seite zur Einstellung weiterer Eigenschaften beschichtet werden. Typische Beschichtungen sind haftvermittelnde, antistatisch, schlupfverbessernd oder dehäsiv wirkende Schichten. Es bietet sich an, diese zusätzlichen Schichten über in-linecoating mittels wässriger Dispersionen nach der Längs- und vor der Querstreckung auf die Folie aufzubringen.

Für bestimmte Anwendungen kann es zweckmäßig sein, die Oberfläche der Folie, die nicht mit hydrolysierten Aminosilanverbindungen beschichtet wurde, mit einer Säure chemisch vorzubehandeln. Für diese sogenannte Ätzhaftvermittlung eignen sich insbesondere Trichloressigsäure, Dichloressigsäure oder Flusssäure, die für eine kurze Zeit (zwischen 5 und 120 Sekunden) auf die Oberfläche einwirken und dann mittels Luftmesser wieder entfernt werden. Dadurch erhält die Folie eine sehr reaktive, amorphe Oberfläche.

Die Additive, also die strahlungsaktivierbare Metallverbindung sowie die gegebenenfalls vorhandenen weiteren Füllstoffe und sonstigen Additive, können mittels eines handelsüblichen Zweischneckenextruders (z.B. von Coperion) in das Polymer eingebracht werden. Dabei wird ein erfindungsgemäßes Polyestergranulat zusammen mit den Partikeln/Additiven in den Extruder eingebracht und extrudiert, anschließend in einem Wasserbad abgeschreckt und dann granuliert.

In einem bevorzugten Verfahren zur Herstellung der erfindungsgemäßen Polyester werden die Additive aber direkt bei der Polyesterherstellung zugegeben. Üblicherweise werden die Additive im Falle des DMT-Verfahrens nach der Umesterung bzw. direkt vor der Polykondensation (z.B. in der Transportleitung zwischen Umesterungs- und Polykondensationskessel) als glykolische Dispersion zugegeben. Die Zugabe kann aber auch schon vor der Umesterung erfolgen. Im Falle des TPA-Verfahrens erfolgt die Zugabe bevorzugt zu Beginn der Polykondensation. Eine spätere Zugabe ist jedoch auch möglich. Es hat sich bei diesem Verfahren als günstig erwiesen, wenn die glykolischen Dispersionen vor der Zugabe über einen PROGAF PGF 57 (Hayward Ind., USA) Filter filtriert werden.

Gegenstand der vorliegenden Erfindung ist auch ein Verfahren zur Herstellung der Folie. Allgemein erfolgt die Herstellung durch ein an sich bekanntes Extrusions- oder Koextrusionsverfahren. Als besonders vorteilhaft hat es sich erwiesen, die strahlungaktivierbare Komponente und die ggf. verwendeten weiteren Additive, wie Partikel, UV-Stabilisatoren, Flammschutzmittel, Hydrolysestabilisatoren und Antioxidantien in Form von vorgetrockneten oder vorkristallisierten Masterbatchen vor der Extrusion zuzugeben.

Bevorzugt bei der Masterbatchtechnologie ist, dass die Korngröße und das Schüttgewicht der Masterbatche ähnlich der Korngröße und dem Schüttgewicht des verwendeten Polyesterrohstoffs ist, so dass eine homogene Verteilung erreicht wird, aus der homogene Eigenschaften resultieren.

Die Polyesterfolien können nach bekannten Verfahren aus einem Polyesterrohstoff, und gegebenenfalls weiteren Rohstoffen, mindestens einer strahlungsaktivierbaren Komponente sowie gegebenenfalls weiteren Additiven als ein- oder mehrschichtige Folie hergestellt werden.

Masterbatche, die die strahlungsaktivierbare Komponente enthalten, sind bevorzugt vorkristallisiert und/oder vorgetrocknet. Das gleiche gilt für Masterbatche, die Partikel, UV-Stabilisator(en), Flammschutzmittel und/oder andere Additive enthalten. Die Vortrocknung beinhaltet ein graduelles Erhitzen der Masterbatche unter reduziertem Druck (20 bis 80 mbar, vorzugsweise 30 bis 60 mbar, insbesondere 40 bis 50 mbar) sowie Rühren und gegebenenfalls ein Nachtrocknen bei konstanter, erhöhter Temperatur (ebenfalls unter reduziertem Druck). Die Masterbatche werden vorzugsweise bei Raumtemperatur aus einem Dosierbehälter in der gewünschten Abmischung zusammen mit dem Polyesterrohstoff und gegebenenfalls anderen Rohstoffkomponenten chargenweise in einen Vakuumtrockner, der im Laufe der Trocken- bzw. Verweilzeit ein Temperaturspektrum von 10 bis 160 °C, vorzugsweise 20 bis 150 °C, insbesondere 30 bis 130 °C, durchläuft, gefüllt. Während der etwa 6-stündigen, vorzugsweise 5-stündigen, insbesondere 4-stündigen Verweilzeit wird die Rohstoffmischung mit 10 bis 70 Upm, vorzugsweise 15 bis 65 Upm, insbesondere 20 bis 60 Upm, gerührt. Das so vorkristallisierte bzw. vorgetrocknete Rohstoffgemisch wird in einem nachgeschalteten ebenfalls evakuierten Behälter bei 90 bis 180 °C, vorzugsweise 100 bis 170 °C, insbesondere 110 bis 160 °C, für 2 bis 8 Stunden, vorzugsweise 3 bis 7 Stunden, insbesondere 4 bis 6 Stunden, nachgetrocknet.

Bei dem bevorzugten Extrusionsverfahren zur Herstellung der Folie wird das Polymermaterial mit den Additiven der einzelnen Schichten in einem Extruder aufgeschmolzen.

Die Schmelze(n) wird (werden gleichzeitig) durch eine Breitschlitzdüse gepresst und als weitgehend amorphe Vorfolie abgeschreckt. Diese Vorfolie wird anschließend erneut erhitzt und in mindestens einer Richtung - entweder in Maschinenrichtung (MD) oder in Querrichtung (TD) - bevorzugt aber in Längs- und Querrichtung bzw. in Quer-und Längsrichtung bzw. in Längs-, in Quer- und nochmals und Längsrichtung und/oder Querrichtung verstreckt ("orientiert"). Die Folientemperaturen im Streckprozess liegen im allgemeinen 10 bis 60 °C über der Glasübergangstemperatur Tg des verwendeten Polyesters, das Streckverhältnis der Längsstreckung liegt üblicherweise bei 2,0 bis 6,0, insbesondere bei 3,0 bis 4,5, das der Querstreckung bei 2,0 bis 5,0, insbesondere bei 3,0 bis 4,5, und das der gegebenenfalls durchgeführten zweiten Längs- und Querstreckung bei 1,1 bis 5,0. Die Längs- und Querstreckung kann auch gleichzeitig miteinander (Simultanstreckung) oder in beliebiger Sequenzfolge durchgeführt werden.

Es folgt die Thermofixierung der Folie bei Ofentemperaturen von 180 bis 260 °C, insbesondere von 220 bis 250 °C. Anschließend wird die Folie abgekühlt und gewickelt.

In einer bevorzugten Ausführungsform findet die Thermofixierung zwischen 220 bis 250 °C statt und die Folie wird bei dieser Temperatur um mindestens 1 % (bevorzugt mindestens 2 %) in Querrichtung relaxiert.

In einer weiteren bevorzugten Ausführungsform findet die Thermofixierung zwischen 220 bis 250 °C statt und die Folie wird bei dieser Temperatur um mindestens 1 % (bevorzugt mindestens 2 %) in Querrichtung relaxiert und anschließend nochmals bei Temperaturen zwischen 180 und 150 °C in der Abkühlphase um wiederum mindestens 1 % (bevorzugt mindestens 2 %) in Querrichtung relaxiert.

In einer weiteren bevorzugten Ausführungsform wird die Folie mindestens um den Faktor 3,0 in MD- und TD-Richtung gestreckt, wobei die Streckung in einem Simultanrahmen stattfindet. Die Thermofixierung findet zwischen 220 bis 250 °C statt, und die Folie wird bei dieser Temperatur um mindestens 1 % in Längs- und Querrichtung relaxiert.

Die erfindungsgemäßen Folien weisen die geforderten guten mechanischen Eigenschaften auf. So beträgt der E-Modul in mindestens einer Folienrichtung (Längsrichtung (MD) und/oder Querrichtung (TD)) mindestens 500 N/mm², bevorzugt mindestens 2000 N/mm² und besonders bevorzugt mindestens 4000 N/mm². Die Reißfestigkeitswerte in mindestens einer Folienrichtung (Längsrichtung (MD) und/oder Querrichtung (TD)) sind größer als 50 N/mm², bevorzugt größer als 100 N/mm² und besonders bevorzugt größer als 150 N/mm². Die Reißdehnungswerte in mindestens einer Folienrichtung (Längsrichtung (MD) und/oder Querrichtung (TD)) sind größer als 10 % bevorzugt größer als 40 % und besonders bevorzugt größer als 80 %.

Die erfindungsgemäße Folie weist in keiner Folienrichtung (weder in MD noch in TD) einen Schrumpf bei 200 °C von größer 25 % auf. Der Schrumpf bei 200 °C ist sogar kleiner als 15 % und bevorzugt kleiner als 5 %.

Es war mehr als überraschend, dass durch den Einsatz der beschriebenen Additive und der Beschichtung mit einer hydrolysierten Aminosilanverbindung, gegebenenfalls kombiniert mit einer geeigneten Vortrocknung und / oder Vorkristallisation der Rohstoffe und den beschriebenen Verfahrensbedingungen eine durch elektromagnetische Strahlung aktivierbare ein- oder mehrschichtige Folie mit dem geforderten Eigenschaftsprofil ohne technische Probleme (wie Verklebungen im Trockner oder Abrisse) herstellbar ist. Es wurden bei der Herstellung kaum oder keine Ablagerungen an den Düsen oder Ausgasungen beobachtet, wodurch die erfindungsgemäße Folie ausgezeichnete mechanische Eigenschaften, eine exzellente Optik, ein ausgezeichnetes Profil und eine ausgezeichnete Planlage aufweist. Sie lässt sich hervorragend verstrecken, so dass sie verfahrenssicher und wirtschaftlich rentabel hergestellt werden kann und zeigt nach Aktivierung mit elektromagnetischer Strahlung und nachfolgender Metallisierung eine gute Haftung zwischen Metall und Folie.

Des weiteren ist es sehr überraschend, dass auch das Rezyklat der beschichteten Folie wieder einsetzbar ist, ohne die mechanischen und elektrischen Eigenschaften der Folie negativ zu beeinflussen. Auch im Vergleich zu einer nicht ausgerüsteten Folie sind die elektrischen und mechanischen Eigenschaften im Rahmen der Messgenauigkeit nicht negativ verändert.

Durch die Kombination ihrer Eigenschaften eignen sich die erfindungsgemäßen Folien für eine Vielzahl verschiedener Anwendungen, beispielsweise für Leiterplatten, Flachbandkabel, Smartcards, RFID-Labels, Folientastaturen und folienbasierten Schaltungen aller Art.

Die Erfindung wird im Folgenden anhand von Ausführungsbeispielen näher erläutert, ohne darauf beschränkt zu sein.

Die Messung der einzelnen Eigenschaften erfolgt dabei gemäß der folgenden Normen bzw. Verfahren.

### Messmethoden

### Mechanische Eigenschaften

Der E-Modul, die Reißfestigkeit, Reißdehnung und der F5-Wert werden in Längs- und Querrichtung nach ISO 527-1-2 mit Hilfe eines Zug-Dehnungsmessgerät (Fa. Zwick, Typ 010, Ulm, DE) gemessen.

### Schrumpf

Der thermische Schrumpf wurde an quadratischen Folienmustern mit einer Kantenlänge von 10 cm bestimmt. Die Proben werden genau ausgemessen (Kantenlänge L₀) und werden 15 Minuten bei 200 °C in einem Umlufttrockenschrank getempert. Die Proben werden entnommen und bei Raumtemperatur genau ausgemessen (Kantenlänge L). Der Schrumpf ergibt sich aus der Gleichung

Schrumpf [%] = 100 • (L₀ - L)/L

### Standardviskosität (SV) und intrinsische Viskosität (IV)

Die Standardviskosität SV wurde - angelehnt an DIN 53726 - als 1 %ige Lösung in Dichloressigsäure (DCE) bei 25 °C gemessen. SV (DCE) = (ηᵣₑₗ -1) x 1000. Die intrinsische Viskosität (IV) berechnet sich wie folgt aus der Standardviskosität (SV)

IV = [η] = 6.907 • 10⁻⁴ SV (DCE) + 0,063096 [dl/g]

### Messung des mittleren Durchmessers d₅₀:

Die Bestimmung des mittleren Durchmessers d₅₀ wurde mittels Laser auf einem Malvern Master Sizer nach der Standardmethode durchgeführt (andere Messgeräte sind z.B. Horiba LA 500 oder Sympathec Helos, welche das gleiche Messprinzip verwenden). Die Proben wurden dazu in eine Küvette mit Wasser gegeben und diese dann in das Messgerät gestellt. Der Messvorgang ist automatisch und beinhaltet auch die mathematische Bestimmung des d₅₀-Wertes.
Der d₅₀-Wert wird dabei definitionsgemäß aus der (relativen) Summenkurve der Partikelgrößenverteilung bestimmt: Der Schnittpunkt des 50 % Ordinatenwertes mit der Summenkurve liefert auf der Abszissenachse sofort den gewünschten d₅₀-Wert. Wie dies zu verstehen ist wird in der nachstehenden Abbildung näher verdeutlicht:

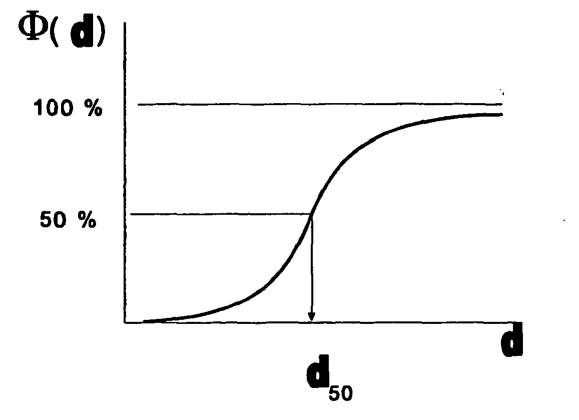

### Siegelnahtfestigkeit

Zur Bestimmung der Siegelnahtfestigkeit wurde zwei 15 mm breite Folienstreifen übereinandergelegt und bei 130 °C, einer Siegelzeit von 0,5 s und einem Siegeldruck von 2 bar mit einem Gerät Typ NDS der Fa. Brugger Feinmechanik (München, DE) mit einseitig beheizter Siegelbacke gesiegelt. Die Siegelnahtfestigkeit wurde nach der T-Peel-Methode mit Hilfe eines Zug-Dehnungsmessgerät (Fa. Zwick, Typ 010, Ulm, DE) bestimmt. Dabei werden die beiden Streifenenden in die gegenüberliegenden Kluppen eingespannt und mit einer Geschwindigkeit von 200 mm/min auseinandergezogen. Die maximale dabei gemessenen Kraft ist die Siegelnahtfestigkeit und wird in N/15 mm angegeben.

### Folienherstellung

Polyester-Chips wurden gemäß den in den Beispielen angegebenen Verhältnissen gemischt und in einem Wirbelschichttrockner bei 155 °C für 1 Minute vorkristallisiert, anschließend für 3 Stunden in einem Schachttrockner bei 150 °C getrocknet und bei 290 °C in einem Einschneckenextruder aufgeschmolzen. Die geschmolzene Polymerstränge wurde in einer Koextrusionsdüse zusammengeführt und über eine Abzugswalze (Temperatur der Walze 20 °C) abgezogen. Der Film wurde um den Faktor 3,5 in Maschinenrichtung bei 116 °C (Folientemperatur im Streckspalt) gestreckt. Anschließend wurde die Folie nach einer Coronabehandlung einseitig mit wässriger Aminosilandispersion mittels Reverse-Gravure-Coating beschichtet'(Bedingungen: 2,0 Gew.-% Z-6020 von Fa. Dow Corning (DE) in entionisiertem Wasser, Nassantragsgewicht: 2,5 g/m², entspricht einem Trockenantragsgewicht von 16 mg/m²). In einem Rahmen wurde bei 110 °C eine Querstreckung um den Faktor 3,2 durchgeführt. Anschließend wurde die Folie bei 229 °C thermofixiert und in Querrichtung um 1 % bei Temperaturen von 229 - 200 und ein weiteres mal um 1 % bei Temperaturen zwischen 180 °C und 150 °C relaxiert. Die Produktionsgeschwindigkeit (Endfoliengeschwindigkeit) beträgt 300 m/min.
Die Endfoliendicke beträgt 50 µm.

### Beispiele

In den Beispielen kommen die folgenden Rohstoffe zum Einsatz:

### Masterbatch MB1:

10 Gew.-% PK3095 der Firma Ferro und 90 Gew.-% Polyethylenterephtalat (PET)

### Masterbatch MB2:

10 Gew.-% PK3095 der Firma Ferro und 90 Gew.-% Polybutylenterephtalat (PBT)

### Masterbatch MB3:

4 Gew.-% SiO₂-Partikel Aerosil TT600 der Firma Degussa (Deutschland) (d₅₀ der Agglomerate ca. 300 nm; Primärteilchen d₅₀ ca. 50 nm) und 96 Gew.-% Polyethylenterephtalat (PET).

### Masterbatch MB4:

4 Gew.-% SiO₂-Partikel Aerosil TT600 der Firma Degussa (Deutschland) (d₅₀ der Agglomerate ca. 300 nm; Primärteilchen d₅₀ ca. 50 nm) und 96 Gew.-% Polybutylenterephtalat (PBT).

### Masterbatch MB5:

4 Gew.-% CaCO₃-Partikel Omyacarb BP der Firma Omya (USA) (d₅₀ der Partikel 22 µm), 96 Gew.-% Polyethylenterephtalat (PET).

### Masterbatch MB6:

10 Gew.-% PK3095 der Firma Ferro und 90 Gew.-% Polyethylennaphtalat (PEN)

### Masterbatch MB7:

4 Gew.-% SiO₂-Partikel Aerosil TT600 der Firma Degussa (Deutschland) (d₅₀ der Agglomerate ca. 300 nm; Primärteilchen d₅₀ ca. 50 nm) und 96 Gew.-% Polyethylennaphtalat (PEN).

### Masterbatch MB8:

4 Gew.-% CaCO₃-Partikel Hydrocarb 70 mit einem d₅₀-Wert von 1,6 µm (Fa. Omya) (Deutschland), 96 Gew.-% Polyethylenterephtalat (PET).

### Masterbatch MB9:

Das Masterbatch MB9 enthält 6 Gew.-% M-Ester der Firma Sanko Co. Ltd. (Cas Nr. 63562-34-5) und 94 Gew.-% Polyethylenterephthalat der Firma KoSa.

### Rohstoff R1:

100 Gew.-% Polyethylenterephthalat RT49 der Firma Kosa (Deutschland)

### Rohstoff R2:

25 Gew.-% Aerosil 90 der Firma Degussa (Deutschland), 5 Gew.-% PK3095 der Firma Ferro und 70 Gew.-% Polybutylenterephtalat (PBT)

### Rohstoff R3:

100 Gew.-% Polybutylenterephthalat

### Rohstoff R4:

100 Gew.-% Polyethylennaphthalat

### Beispiel 1

50 Gew.-% MB1 werden mit 25 Gew.-% MB3 und 25 Gew.-% R1 gemischt und wie oben angegeben zu einer einseitig beschichteten Monofolie weiterverarbeitet. Die Eigenschaften können der Tabelle 1 entnommen werden.

### Beispiel 2

Beispiel 1 wird wiederholt, wobei zusätzlich 50 Gew.-% Rezyklat, hergestellt aus der Folie aus Beispiel 1, eingesetzt wird. Die Eigenschaften können der Tabelle 1 entnommen werden.

### Beispiel 3

50 Gew.-% MB1 werden mit 50 Gew.-% R1 gemischt und wie oben angegeben zu einer einseitig beschichteten Monofolie weiterverarbeitet. Die Eigenschaften können der Tabelle 1 entnommen werden.

### Beispiel 4

Es wird eine einseitig beschichtete ABA-Folie mit einer Dicke der Basisschicht von 46 µm und Deckschichten A mit je 2 µm wie oben angegeben hergestellt.
Rohstoffmischung Deckschichten A: 50 Gew.-% MB1; 25 Gew.-% MB3; 25 Gew.-% R1
Rohstoffmischung Basisschicht B: 100 Gew.-% R1
Die Eigenschaften der Folie können Tabelle 1 entnommen werden.

### Beispiel 5

Es wird eine einseitig beschichtete ABC-Folie mit einer Dicke der Basisschicht von 46 µm und Deckschichten A und C mit je 2 µm wie oben angegeben hergestellt.
Rohstoffmischung Deckschicht A: 50 Gew.-% MB1; 25 Gew.-% MB3; 25 Gew.-% R1
Rohstoffmischung Basisschicht B: 100 Gew.-% R1
Rohstoffmischung Deckschicht C: 25 Gew.-% MB3; 75 Gew.-% R1
Die Eigenschaften der Folie können Tabelle 1 entnommen werden.

### Beispiel 6

Es wird eine einseitig beschichtete ABA-Folie mit einer Dicke der Basisschicht von 46 µm und Deckschichten A mit je 2 µm wie oben angegeben hergestellt.
Rohstoffmischung Deckschicht A: 50 Gew.-% MB1; 25 Gew.-% MB3; 25 Gew.-% R1
Rohstoffmischung Basisschicht B: 25 Gew.-% MB9; 75 Gew.-% R1

Die Folie wurde einem Brandtest gemäß UL94 VTM unterzogen und erreichte die Brandklasse VTM-0. Die sonstigen Eigenschaften der Folie können Tabelle 1 entnommen werden.

### Beispiel 7

Es wird eine auf der A-Seite beschichtete ABC-Folie mit einer Dicke der Basisschicht von 47 µm, einer Deckschicht A mit 2 µm und einer siegelfähigen Deckschicht C mit 1 µm wie oben angegeben hergestellt.
Rohstoffmischung Deckschicht A: 50 Gew.-% MB1; 25 Gew.-% MB3; 25 Gew.-% R1
Rohstoffmischung Basisschicht B: 100 Gew.-% R1
Rohstoffmischung Deckschicht C: 100 Gew.-% R6

Die Siegelnahtfestigkeit der Folie (C-Seite / C-Seite) betrug 2,5 N/15 mm. Die sonstigen Eigenschaften der Folie können Tabelle 1 entnommen werden.

### Beispiel 8

40 Gew.-% MB6 werden mit 25 Gew.-% MB7 und 25 Gew.-% R4 gemischt und wie oben angegeben zu einer einseitig beschichteten Monofolie weiterverarbeitet. Die Eigenschaften können der Tabelle 1 entnommen werden.

### Vergleichsbeispiel 1

Es wurde versucht wie oben angegeben aus dem Rohstoff R2 (angelehnt an den Rohstoff aus dem Beispiel aus EP-A-1 274 288) eine einseitig beschichtete Folie herzustellen. Die Verstreckung der Folie erwies sich als unmöglich, da jeder Streckversuch zu Abrissen führte. Es konnte keine Folie hergestellt werden.

### Vergleichsbeispiel 2

Beispiel 1 wird wiederholt, wobei die Folie allerdings nicht beschichtet wird. Die Eigenschaften können der Tabelle 1 entnommen werden.

### Vergleichsbeispiel 3

60 Gew.-% MB1 werden mit 40 Gew.-% MB5 gemischt und wie oben angegeben zu einer einseitig beschichteten Folie weiterverarbeitet. Es konnten nur kleine Mengen erzeugt werden, da es bei der Herstellung häufig zu Abrissen bei der Streckung kam. Eine wirtschaftliche Herstellung der Folie ist nicht möglich. Die Eigenschaften können der Tabelle 1 entnommen werden.

### Vergleichsbeispiel 4

50 Gew.-% MB1 werden mit 25 Gew.-% MB3 und 25 Gew.-% R1 gemischt und wie oben angegeben zu einer einseitig beschichteten Folie weiterverarbeitet. Die Thermofixierung erfolgt jedoch nicht wie oben beschrieben bei 229 °C sondern bei 150 °C und es erfolgte keine Relaxation. Die Eigenschaften können der Tabelle 1 entnommen werden.

### Leiterbahnerzeugung:

Die hergestellten Folien werden im Bereich der aufzubringenden Leiterbahnen auf der mit Aminosilan beschichteten Seite mit einer Infrarot-Laserstrahlung, die von einem diodengepumpten Nd:YAG-Laser erzeugt wird (hier Microline 3D IR 160 der Firma LPKF AG (Deutschland)), mit einer Intensität bestrahlt, die einen geringfügigen Abtrag erzeugt, der mit einer strukturierten Entstehung von Metallkeimen verbunden ist. Nach kurzer Behandlung in einem demineralisiertes Wasser enthaltenden Ultraschall-Reinigungsbad wird die Folie durch ein handelsübliches chemisch reduktives Verkupferungsbad geführt. Hier werden in den bestrahlten Bereichen die Leiterbahnen aufgebaut.

### Ergebnisse der Leiterbahnerzeugung:

Die erzeugten Leiterbahnen wurden mittels eines Lichtmikroskops (Auflicht) bei 20-facher Vergrößerung visuell beurteilt. Die Geschlossenheit der Kupferschicht wurde visuell bewertet und in die folgenden Kategorien eingeteilt: gut, weniger gut und schlecht. Zur Beurteilung der Haftung des abgeschiedenen Metalls auf der Folie wurde, wie oben beschrieben, eine Leiterbahn (Länge: 2,5 cm; Breite: 3 mm) durch Aktivierung und nachfolgende Verkupferung hergestellt. Anschließend wurde quer über die Leiterbahn ein Klebestreifen (® Scotch Tape 600 von 3M, USA) geklebt. Der Klebestreifen wurde in einem Winkel von 90° zur Folienoberfläche mit einer konstanten Geschwindigkeit von 0,2 cm/s abgezogen. Der Klebestreifen wurde unter dem Lichtmikroskop (Auflicht) bei 20-facher Vergrößerung betrachtet. Falls kein abgelöstes Kupfer auf der Klebefläche sichtbar war, wurde die Haftung des Kupfers auf der Folie mit "ausreichend" (+) bewertet, anderenfalls war die Haftung "nicht ausreichend" (-).

**Tabelle 1**

| Beispiel | E-Modul MD in N/mm² | E-Modul TD in N/mm² | Reißfestigkeit MD in N/mm² | Reißfestigkeit TD in N/mm² | Reißdehnung MD in % | Reißdehnung TD in % | Schrumpf MD 200 °C | Schrumpf TD 200 °C | Leiterbahnerzeugung | Haftung des Kupfers |
|---|---|---|---|---|---|---|---|---|---|---|
| 1 | 4200 | 5300 | 190 | 280 | 170 | 110 | 4,2 | 2,7 | gut | + |
| 2 | 4200 | 5400 | 185 | 282 | 165 | 115 | 4,3 | 2,0 | gut | + |
| 3 | 4100 | 5500 | 172 | 278 | 163 | 100 | 4,5 | 2,3 | weniger gut | + |
| 4 | 4400 | 5700 | 192 | 295 | 167 | 105 | 3,9 | 1,5 | gut | + |
| 5 | 4000 | 5100 | 181 | 240 | 177 | 117 | 4,6 | 3,1 | gut | + |
| 6 | 3900 | 4800 | 162 | 210 | 181 | 119 | 5,2 | 3,3 | gut | + |
| 7 | 4800 | 6100 | 210 | 300 | 155 | 95 | 3,5 | 1,9 | gut | + |

| Vergleichsbeispiel | | | | | | | | | | |
|---|---|---|---|---|---|---|---|---|---|---|
| 1 | keine Folie erhalten | keine Folie erhalten | keine Folie erhalten | keine Folie erhalten | keine Folie erhalten | keine Folie erhalten | keine Folie erhalten | keine Folie erhalten | keine Folie erhalten | keine Folie erhalten |
| 2 | 4000 | 5100 | 182 | 275 | 178 | 112 | 4,0 | 2,3 | schlecht | - |
| 3 | 4300 | 5200 | 45 | 37 | 19 | 31 | 4,6 | 3,0 | gut | + |
| 4 | 4100 | 5500 | 180 | 287 | 185 | 108 | 25 | 29 | gut*) | + |

| | | | | | | | | | | |
|---|---|---|---|---|---|---|---|---|---|---|
| *) Nach Laserbestrahlung bildeten sich Falten | | | | | | | | | | |

## Patentansprüche

1. Ein- oder mehrschichtige, mindestens monoaxial orientierte Polyesterfolie mit einer Gesamtdicke von 5 - 500 µm, **dadurch gekennzeichnet, dass** sie eine Metallverbindung enthält, die bei Bestrahlung mit elektromagnetischer Strahlung in dem Polyester Metall in elementarer Form freisetzt und die mindestens auf einer ihrer Oberflächen mit einer Aminosilanbeschichtung versehen ist.

2. Polyesterfolie nach Anspruch 1, **dadurch gekennzeichnet, dass** die Metallverbindung ein Metalloxid ist.

3. Polyesterfolie nach Anspruch 1 oder 2, **dadurch gekennzeichnet, dass** die Metallverbindung ein Spinell ist.

4. Polyesterfolie nach einem der Ansprüche 1 bis 3, **dadurch gekennzeichnet, dass** die Metallverbindung CuCr₂O₄ ist.

5. Polyesterfolie nach einem der Ansprüche 1 bis 4, **dadurch gekennzeichnet, dass** die Metallverbindung in der Folie in einer Menge von 0,1 bis 15,0 Gew.-% enthalten ist.

6. Polyesterfolie nach einem der Ansprüche 1 bis 5, **dadurch gekennzeichnet, dass** sie partikuläre Additive enthält.

7. Polyesterfolie nach einem der Ansprüche 1 bis 6, **dadurch gekennzeichnet, dass** die Aminosilanbeschichtung mit einem Aminosilan vorgenommen wird, welches im unhydrolysierten Zustand die allgemeine Formel
(R¹)ₐSi(R²)_{b}(R³)_{c}
aufweist,
wobei R¹ eine funktionelle Gruppe mit mindestens einer primären Aminogruppe ist, bevorzugt eine Gruppe mit der Formel -X-Y-Z-NH₂ mit X=C1-C4-Alkylen o. C6-C10-Arylen, Y= O, NH oder eine Bindung, Z=C1-C4-Alkylen o. C6-C10-Arylen, R² eine hydrolysierbare Gruppe ist, ausgewählt aus der Gruppe, bestehend aus einer Alkoxygruppe mit 1 - 8 Kohlenstoffatomen, einer Acetoxygruppe und einem Halogenid, und R³ eine unreaktive, nicht hydrolysierbare Gruppe ist, ausgewählt aus der Gruppe, bestehend aus einer Alkylgruppe mit 1 - 8 Kohlenstoffatomen und einer Phenylgruppe, und der Koeffizient a größer oder gleich 1 ist, der Koeffizient b ebenfalls größer oder gleich 1 ist, der Koeffizient c größer oder gleich 0 ist und a+b+c = 4 ist.

8. Polyesterfolie nach einem der Ansprüche 1 bis 7, **dadurch gekennzeichnet, dass** mindestens eine Schicht aus einem Polyester aufgebaut ist, der als Dicarbonsäurekomponente 10 bis 100 Mol-% Terephthalat enthält (bezogen auf die Gesamtmenge der vorhandenen Dicarbonsäurekomponenten).

9. Polyesterfolie nach einem der Ansprüche 1 bis 8, **dadurch gekennzeichnet, dass** mindestens eine Schicht aus einem Polyester aufgebaut ist, der als Dicarbonsäurekomponente 10 bis 100 Mol-% 2,6-Naphthalat enthält (bezogen auf die Gesamtmenge der vorhandenen Dicarbonsäurekomponenten).

10. Polyesterfolie nach einem der Ansprüche 1 bis 9, **dadurch gekennzeichnet, dass** sie einen E-Modul in mindestens einer Folienrichtung (Längsrichtung (MD) und/oder Querrichtung (TD)) von größer als 500 N/mm² aufweist.

11. Polyesterfolie nach einem der Ansprüche 1 bis 10, **dadurch gekennzeichnet, dass** sie Reißfestigkeitswerte in mindestens einer Folienrichtung (Längsrichtung (MD) und/oder Querrichtung (TD)) von größer als 50 N/mm² aufweist.

12. Polyesterfolie nach einem der Ansprüche 1 bis 11, **dadurch gekennzeichnet, dass** sie Reißdehnungswerte in mindestens einer Folienrichtung (Längsrichtung (MD) und/oder Querrichtung (TD)) von größer als 10 % aufweist.

13. Polyesterfolie nach einem der Ansprüche 1 bis 12, **dadurch gekennzeichnet, dass** sie in keiner Folienrichtung (weder in MD noch in TD) einen Schrumpf bei 200 °C von größer 25 % aufweist.

14. Polyesterfolie nach einem der Ansprüche 1 bis 13, **dadurch gekennzeichnet, dass** die Folie mindestens zweischichtig ist und mindestens aus einer Basisschicht und einer Deckschicht besteht.

15. Polyesterfolie nach einem der Ansprüche 1 bis 14, **dadurch gekennzeichnet, dass** die Folie mindestens dreischichtig ist und mindestens aus einer Basisschicht und zwei Deckschichten besteht.

16. Polyesterfolie nach einem der Ansprüche 14 oder 15, **dadurch gekennzeichnet, dass** die Metallverbindung in einer der Schichten der Mehrschichtfolie vorhanden ist.

17. Polyesterfolie nach einem der Ansprüche 14 oder 15, **dadurch gekennzeichnet, dass** die Metallverbindung in der oder den Deckschichten der Mehrschichtfolie vorhanden ist.

18. Polyesterfolie nach einem der Ansprüche 14 oder 15, **dadurch gekennzeichnet, dass** eine der Deckschichten siegelfähig ist.

19. Verfahren zur Herstellung einer Polyesterfolie nach Anspruch 1, **dadurch gekennzeichnet, dass** man einen Polyesterrohstoff und eine Metallverbindung, die bei Bestrahlung mit elektromagnetischer Strahlung in dem Polyester Metall in elementarer Form freisetzt, zusammen durch eine Schlitzdüse extrudiert, abkühlt, erneut erhitzt und anschließend mindestens in einer Richtung orientiert, anschließend auf einer Oberfläche mit einem hydrolysierten Aminosilan beschichtet und dann thermofixiert.

20. Verwendung einer Folie nach Anspruch 1 in Leiterplatten; Flachbandkabeln, Smartcards, RFID-Labels, Folientastaturen und folienbasierten Schaltungen.

21. Verwendung einer Metallverbindung, die bei Bestrahlung mit elektromagnetischer Strahlung Metall in elementarer Form freisetzt zur Herstellung von mehrschichtigen Folien.

22. Verwendung einer Metallverbindung, die bei Bestrahlung mit elektromagnetischer Strahlung Metall in elementarer Form freisetzt zur Herstellung von Leiterplatten, Flachbandkabeln, Smartcards, RFID-Labels, Folientastaturen und folienbasierten Schaltungen.

## Claims

1. A single- or multilayer, at least monoaxially oriented polyester film with a total thickness of from 5 to 500 µm, which comprises a metal compound which on irradiation with electromagnetic radiation liberates metal in elemental form within the polyester and which has, at least on one of its surfaces, an aminosilane coating.

2. The polyester film as claimed in claim 1, wherein the metal compound is a metal oxide.

3. The polyester film as claimed in claim 1 or 2, wherein the metal compound is a spinel.

4. The polyester film as claimed in any of claims 1 to 3, wherein the metal compound is CuCr₂O₄.

5. The polyester film as claimed in any of claims 1 to 4, wherein the amount of the metal compound present in the film is from 0.1 to 15.0 % by weight.

6. The polyester film as claimed in any of claims 1 to 5, which comprises particulate additives.

7. The polyester film as claimed in any of claims 1 to 6, wherein the aminosilane coating uses an aminosilane which in the unhydrolyzed state has the formula
(R¹)ₐSi(R²)_{b}(R³)_{c}
where R¹ is a functional group having at least one primary amino group, and is preferably a group having the formula -X-Y-Z-NH₂, where X = C1-C4-alkylene or C6-C10-arylene, Y = O, NH, or a bond, Z = C1-C4-alkylene or C6-C10-arylene, R² is a hydrolyzable group selected from the group consisting of an alkoxy group having from 1 to 8 carbon atoms, an acetoxy group, and a halide, and R³ is an unreactive, non-hydrolyzable group selected from the group consisting of an alkyl group having from 1 to 8 carbon atoms and a phenyl group, and the coefficient a is greater than or equal to 1, the coefficient b is likewise greater than or equal to 1, the coefficient c is greater than or equal to 0, and a + b + c = 4.

8. The polyester film as claimed in any of claims 1 to 7, wherein at least one layer is composed of a polyester which contains, as dicarboxylic acid component, from 10 to 100 mol% of terephthalate (based on the total amount of the dicarboxylic acid components present).

9. The polyester film as claimed in any of claims 1 to 8, wherein at least one layer is composed of a polyester which contains, as dicarboxylic acid component, from 10 to 100 mol% of 2,6-naphthalate (based on the total amount of the dicarboxylic acid components present).

10. The polyester film as claimed in any of claims 1 to 9, which has a modulus of elasticity in at least one film direction (longitudinal (MD) and/or transverse (TD)) greater than 500 N/mm².

11. The polyester film as claimed in any of claims 1 to 10, which has ultimate tensile strength values in at least one film direction (longitudinal (MD) and/or transverse (TD)) greater than 50 N/mm².

12. The polyester film as claimed in any of claims 1 to 11, which has tensile strain at break values in at least one film direction (longitudinal (MD) and/or transverse (TD)) greater than 10 %.

13. The polyester film as claimed in any of claims 1 to 12, which does not have shrinkage greater than 25 % at 200 °C in any film direction (MD or TD).

14. The polyester film as claimed in any of claims 1 to 13, which has at least two layers and is composed at least of one base layer and one outer layer.

15. The polyester film as claimed in any of claims 1 to 14, which has at least three layers and is composed at least of one base layer and two outer layers.

16. The polyester film as claimed in claim 14 or 15, wherein the metal compound is present in one of the layers of the multilayer film.

17. The polyester film as claimed in claim 14 or 15, wherein the metal compound is present in the outer layer(s) of the multilayer film.

18. The polyester film as claimed in claim 14 or 15, wherein one of the outer layers is sealable.

19. A process for producing a polyester film as claimed in claim 1, which comprises extruding, together through a slot die, a polyester and a metal compound which on irradiation with electromagnetic radiation liberates metal in elemental form within the polyester, cooling, reheating, and then orienting in at least one direction, then coating one surface with a hydrolyzed aminosilane, and then heat-setting.

20. The use of a film as claimed in claim 1 in printed circuit boards, ribbon cables, smart cards, RFID labels, membrane keyboards, and film-based circuits.

21. The use of a metal compound which on irradiation with electromagnetic radiation liberates metal in elemental form for producing multilayer films.

22. The use of a metal compound which on irradiation with electromagnetic radiation liberates metal in elemental form for producing printed circuit boards, ribbon cables, smart cards, RFID labels, membrane keyboards, and film-based circuits.

## Revendications

1. Film de polyester mono- ou multicouche, orienté au moins monoaxialement, ayant une épaisseur totale de 5-500 µm, **caractérisé en ce qu'**il contient un composé métallique qui, lors d'irradiation avec un rayonnement électromagnétique, libère dans le polyester du métal sous forme élémentaire et qui est muni sur au moins une de ses faces d'un revêtement à base d'aminosilane.

2. Film de polyester selon la revendication 1, **caractérisé en ce que** le composé métallique est un oxyde métallique.

3. Film de polyester selon la revendication 1 ou 2, **caractérisé en ce que** le composé métallique est un spinelle.

4. Film de polyester selon l'une quelconque des revendications 1 à 3, **caractérisé en ce que** le composé métallique est CuCr₂O₄.

5. Film de polyester selon l'une quelconque des revendications 1 à 4, **caractérisé en ce que** le composé métallique est contenu dans le film en une proportion de 0,1 à 15,0 % en poids.

6. Film de polyester selon l'une quelconque des revendications 1 à 5, **caractérisé en ce qu'**il contient des additifs particulaires.

7. Film de polyester selon l'une quelconque des revendications 1 à 6, **caractérisé en ce que** le revêtement à base d'aminosilane est effectué avec un aminosilane qui à l'état non hydrolysé correspond à la formule générale
(R¹)ₐSi(R²)_{b}(R³)_{c}
dans laquelle R¹ est un groupe fonctionnel comportant au moins un groupe amino primaire, de préférence un groupe de formule -X-Y-Z-NH₂ où X = alkylène en C₁-C₄ ou arylène en C₆-C₁₀, Y = O, NH ou une liaison, Z = alkylène en C₁-C₄ ou arylène en C₆-C₁₀, R² est un groupe hydrolysable choisi dans l'ensemble constitué par un groupe alcoxy ayant de 1 à 8 atomes de carbone, un groupe acétoxy et un halogénure, et R³ est un groupe non hydrolysable, non réactif, choisi dans l'ensemble constitué par un groupe alkyle ayant de 1 à 8 atomes de carbone et un groupe phényle, et le coefficient a est supérieur ou égal à 1, le coefficient b est de même supérieur ou égal à 1, le coefficient c est supérieur ou égal à 0 et a+b+c = 4.

8. Film de polyester selon l'une quelconque des revendications 1 à 7, **caractérisé en ce qu'**au moins une couche est constituée d'un polyester qui contient en tant que composant acide dicarboxylique de 10 à 100 % en moles de téréphtalate (par rapport à la quantité totale des composants de type acide dicarboxylique présents).

9. Film de polyester selon l'une quelconque des revendications 1 à 8, **caractérisé en ce qu'**au moins une couche est constituée d'un polyester qui contient en tant que composant acide dicarboxylique de 10 à 100 % en moles de 2,6-naphtalate (par rapport à la quantité totale des composants de type acide dicarboxylique présents).

10. Film de polyester selon l'une quelconque des revendications 1 à 9, **caractérisé en ce qu'**il présente un module d'élasticité dans au moins un sens du film [sens longitudinal (MD) et/ou sens transversal (TD)] supérieur à 500 N/mm².

11. Film de polyester selon l'une quelconque des revendications 1 à 10, **caractérisé en ce qu'**il présente des valeurs de la résistance à la traction dans au moins un sens du film [sens longitudinal (MD) et/ou sens transversal (TD)] supérieures à 50 N/mm².

12. Film de polyester selon l'une quelconque des revendications 1 à 11, **caractérisé en ce qu'**il présente des valeurs de l'allongement en traction dans au moins un sens du film [sens longitudinal (MD) et/ou sens transversal (TD)] supérieures à 10 %.

13. Film de polyester selon l'une quelconque des revendications 1 à 12, **caractérisé en ce qu'**il ne présente dans aucun sens du film (ni dans MD, ni dans TD) un retrait de plus de 25 % à 200 °C.

14. Film de polyester selon l'une quelconque des revendications 1 à 13, **caractérisé en ce que** le film est au moins bicouche et est au moins constitué d'une couche de base et d'une couche de recouvrement.

15. Film de polyester selon l'une quelconque des revendications 1 à 14, **caractérisé en ce que** le film est au moins tricouche et est au moins constitué d'une couche de base et de deux couches de recouvrement.

16. Film de polyester selon la revendication 14 ou 15, **caractérisé en ce que** le composé métallique est présent dans l'une des couches du film multicouche.

17. Film de polyester selon la revendication 14 ou 15, **caractérisé en ce que** le composé métallique est présent dans la couche ou les couches de recouvrement du film multicouche.

18. Film de polyester selon la revendication 14 ou 15, **caractérisé en ce que** l'une des couches de recouvrement est soudable.

19. Procédé pour la fabrication d'un film de polyester selon la revendication 1, **caractérisé en ce qu'**une matière première polyester et un composé métallique qui, lors d'irradiation avec un rayonnement électromagnétique, libère dans le polyester du métal sous forme élémentaire, sont extrudés ensemble à travers une filière plate, le film est refroidi, chauffé de nouveau et ensuite orienté au moins dans un sens, puis revêtu sur une face avec un aminosilane hydrolysé, et ensuite thermofixé.

20. Utilisation d'un film selon la revendication 1, dans des cartes à circuits imprimés, des câbles en ruban, des cartes à puce, des étiquettes RFID, des claviers souples et des câblages à base de films.

21. Utilisation d'un composé métallique qui, lors d'irradiation avec un rayonnement électromagnétique, libère du métal sous forme élémentaire, pour la fabrication de films multicouches.

22. Utilisation d'un composé métallique qui, lors d'irradiation avec un rayonnement électromagnétique, libère du métal sous forme élémentaire, pour la fabrication de cartes à circuits imprimés, de câbles en ruban, de cartes à puce, d'étiquettes RFID (d'identification fréquence radio), des claviers souples et de câblages à base de films.
